# EUROPEAN PATENT APPLICATION

(11) **EP 2 180 328 A1**
(43) Date of publication of application: **28.04.2010**
(21) Application number: 08018427.8
(22) Date of filing: 22.10.2008
(51) Int. Cl.: G01R 33/06

(54) **Microchip for the detection of poor sources of electrical and magnetic fields**

(71) Applicant: Biomimetics Technologies Inc., Toronto ON M4K 2J9 (CA)
(72) Inventor: Gille, Christoph, 16540 Hohen Neuendorf (DE); Holmes, Chris, 42105 Wuppertal (DE); Israelowitz, Meir, Toronto/ Ontario M6S 2X4 (DE); W.H Rizvi, Syed, Toronto/ Ontario M6S 2X4 (DE); von Schroeder, Herbert p, Toronto/ Ontario M6S 2X4 (DE)
(74) Representative: Junius, Walther

(57) **Abstract**

The invention relates to a Microchip for the detection of poor sources of electrical and/or magnetic fields. To detect such poor electrical sources hidden in a body is a difficult problem for which was found a solution by this invention. The invention solves this problem by a Microchip consisting of a plate (1) with parallel rows of recesses (2), in each recess is a cristal (3) with a magnetic activity, between the rows are one or more wires (4,7) connected with a voltage source (9) and one or more wires connected with a voltmeter (6), the whole surface of the plate with the cristals in the recesses and the wires is embeded in a layer of semiconducting polimeres.

## Description

The invention relates to a Microchip for the detection of poor sources of electrical and/or magnetic fields.

Poor sources of electrical and/or magnetic fields are situated not only in electrical circuits but also in metallic items located in the radiation of transmitters of all kinds. Especially of interest are sources of electrical voltages coming from human or animal bodys because they show places of irregularities in theese bodies. Also these poor sources of electrical voltages create an electrical field what can be measured if it is not superposed by stronger electrical fields

To detect such poor electrical sources hidden in a body is a difficult problem for which was found a solution by this invention.

The invention creates a Microchip for the detection of sources of electrical and/or magnetic fields consisting of a plate with parallel rows of recesses, in each recess is a cristall with a magnetic activity, between the rows are one or more wires connected with a voltage source and one or more wires connected with a voltmeter, the whole surface of the plate with the cristals in the recesses and the wires is embeded in a layer of semiconducting polimeres.

The invention creates also a Microchip for the detection of sources of electrical and/or magnetic fields consisting of a plate with parallel rows of recesses, in each recess is a cristall with a magnetic activity embeded in a semiconducting polymere, in each recess is on the ground a layer of thin metal, between the rows are one or more wires connected with a voltage source and one or more wires connected on one end with the metal layer on the ground of each recess and on the other end with a voltmeter,

This microchip should be brought so close as possible to the object to investigate and the voltmeter will show the biggest voltage if the microchip is nearest to the sought location of the source of the electrical field. By turnig the microchip at a location of the highest measured voltage it is possible to get a further information, a information about the direction of the source of the electrical and/or magnetic field.

The one kind of parallel wires can be connected with a source of current, a second kind of parallel wires can be connected with the voltmeter. It is also possible to connect the source of current and the voltage with the same parallel wires if the the source of current is highly resistive.

The enclosed drawing and the description of the drawing serves to explain the invention:
Fig.1 shows a microchip with parallel wires.
Fig.2 shows a microchip with crossed wires.

The microchip consists of a plate 1 with eight by eight grooves 2, in each groove 2 is laid down a piece of metal on the ground, a drop of a polymer of a gelly consistence and in this a single cristal 3. Between each of two rows of grooves 2 are situated wires 4 connected with a collector rail 5. This collector rail 5 is connected with a voltmeter 6. Between each of two rows of grooves 2 are situated also wires 7 connectet with a collector rail 8 and a source 9 of current to produce an electrical field.

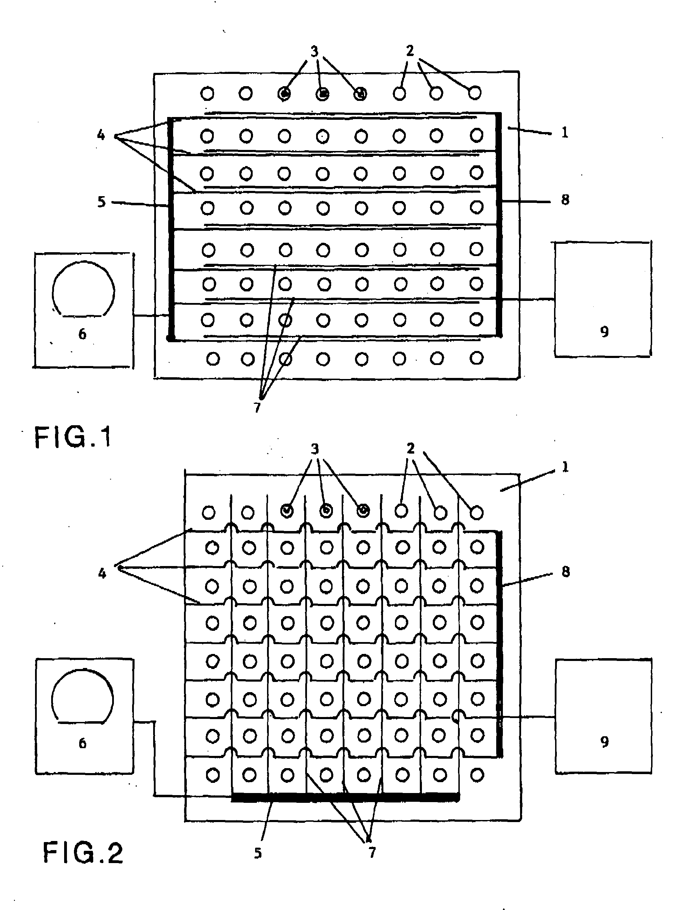

In Fig.1 the wires lay parallel between the rows of grooves, in Fig.2 they cross each other.
The piece of metal in the ground of each hole is connected with the group of the wires 4.

### The microchip works as follows:

The wires 7 produce an electrical and magnetic field. In this electrical field the crystals 3 lay in a distant orientation. Because of the gelly consistence of the polymere in wich the crystals 3 are embetted they turn in another orientation if the field is changed by outer influences. Each turn of a crystal 3 produces an electron in the semiconducting gelly polimere. The produced electrons are lead through the wires 4 to the collector rail 5 and can be measured by the voltmeter 6.
Outer influences are other electrical or magnetic fields superposing the field produced by the wires 7.
These fields can be produced par example in a human or animal body by cancer. The system is connected as follows: the crystal is connected to the polymer and polymer is attached into the hole; the hole is coated with metal, and hole is connected to the wire by the metal coating.
An outer electrical and magnetic field can change the orientation of the crystals and this changes the orientation of the crystals and this produces an electron in the polymer, a metal strip between the the metal coat in the hole and the wire leading to the voltmeter leads the electron to the wire connected with the collecting rail.

List of items in the drawing
- 1: plate
- 2: groove
- 3: cristal
- 4: wire
- 5: collector rail
- 6: voltmeter
- 7: wire
- 8: collector rail
- 9: source of current

## Claims

1. Microchip for the detection of sources of electrical and/or magnetic fields
consisting of a plate with parallel rows of recesses,
in each recess is a cristall with a magnetic activity,
between the rows are one or more wires connected with a voltage source and
one or more wires connected with a voltmeter,
the whole surface of the plate with the cristals in the recesses and
the wires is embeded in a layer of semiconducting polimeres.

2. Microchip for the detection of sources of electrical and/or magnetic fields consisting of a plate with parallel rows of recesses, in each recess is a cristall with a magnetic activity embeded in a semiconducting polymere, in each recess is on the ground a layer of thin metal, between the rows are one or more wires connected with a voltage source and one or more wires connected on one end with the metal layer on the ground of each recess and on the other end with a voltmeter,

3. Microchip according to claim 1 or 2
the crystals are of the family spinal group type Ferroso-Ferric Oxide (Fe₃O₄) and Ferosic Oxide and Sulfur Oxide

4. Microchip according to claim 1 or 2
the layer of semiconducting polimeres is of the type
and Poly(acetylene),
and Poly(pyrrole),
and Poly(aline),
and Poly(fluorens),
Poly(3-alkythionenes),
Poly(tetrathiatuhealeneo),
and Poly(P-phenyele selfide),
and Poly(para-phenylenevinyler)

5. Microchip according to claim 1 or 2
the active field of the plate has dimensions of 8x8 recesses, the diameter of the wires is 10 µm.
